# EUROPEAN PATENT APPLICATION

(11) **EP 4 250 197 A1**
(43) Date of publication of application: **27.09.2023**
(21) Application number: 22164491.7
(22) Date of filing: 25.03.2022
(51) Int. Cl.: G06Q 10/04, G06Q 10/06, G06Q 30/06, G06Q 50/30, G07C 5/08

(54) **A METHOD AND A DIGITAL TWIN FOR DETERMINING AN INFLUENCE ON AN EXPECTED PERFORMANCE OF A HEAVY-DUTY VEHICLE BY ENABLING ONE OR MORE ADD-ON FEATURES**

(71) Applicant: Volvo Truck Corporation, 405 08 Göteborg (SE)
(72) Inventor: RYDSTRÖM, Mats, 427 39 Billdal (SE); ROSGARDT, Tommy, 437 35 Lindome (SE); BENGTSSON, Ingmar, 437 93 Lindome (SE)
(74) Representative: Valea AB

(57) **Abstract**

The present invention relates to a digital twin (105) for determining an influence on an expected performance of a heavy-duty vehicle (100) by enabling one or more add-on features. The digital twin (105) comprises a digital model of the heavy-duty vehicle (100). The digital twin (105) is configured to model at least one of: an operating environment of the heavy-duty vehicle (100) and a transport mission of the heavy-duty vehicle (100). The digital twin (105) is configured to model an as-is performance and an expected performance of the heavy-duty vehicle (100) in at least one of: the operating environment and in executing the transport mission. The digital twin (105) is configured to compare the as-is performance and the expected performance to determine the influence on the expected performance of the heavy-duty vehicle (100) by enabling the one or more add-on features.

## Description

### TECHNICAL FIELD

The present disclosure relates generally to a digital twin and a method performed by the digital twin. More particularly, the present disclosure relates to determining an influence on an expected performance of a heavy-duty vehicle by enabling one or more add-on features.

The invention can be applied in heavy-duty vehicles, such as trucks, buses, and construction equipment. Although the invention will be described with respect to a heavy-duty vehicle, the invention is not restricted to this particular vehicle, but may also be used in other vehicles such as trailers, wheel loaders, articulated haulers, excavators, backhoe loaders, passenger cars, marine vessels, working machines, etc. The term vehicle will be used herein when referring to any of the above types of vehicles.

### BACKGROUND

A vehicle comprises a large number of onboard features of various types. A vehicle may have a set of standard features that all vehicles are equipped with, and there may be optional features that a vehicle customer may choose to add to or enable in his vehicle, either at manufacturing of the vehicle or at a later stage. Thus, the vehicle features may be tailor made for each customer.

As vehicle technology evolves, the set of standard features that all vehicles are quipped with are changing. The number of features in the standard set may increase, the type of features may become more and more complex and advanced, and the type of features may change. Because of this, vehicle customers may be interested in getting newly developed features on their vehicle without having to purchase a new vehicle.

Some features may be of types which influences the performance of the vehicle while driving. For example, different types of tyres may lead to different performance of the vehicle for example in terms of fuel consumption, motion management system based on different technologies may be different in suitability for normal driving conditions compared to challenging driving conditions etc.

The vehicle manufacturer will off course require extra payment for an added feature, and not every customer may necessarily be willing to take such cost for example because he does not know if he will benefit from the added feature or if it will be an unnecessary feature. Therefore, it would be interesting to determine if the performance of the vehicle will be influenced or not with a particular added feature or not.

Therefore, there is a need to at least mitigate or solve these issues.

### SUMMARY

An object of the invention is to provide a method for determining the influence on an expected performance of a heavy-duty vehicle by enabling one or more add-on features.

According to a first aspect of the invention, the object is achieved by a digital twin for determining the influence on the expected performance of the heavy-duty vehicle by enabling one or more add-on features according to claim 1. The digital twin comprises a digital model of the heavy-duty vehicle. The digital twin is configured to model at least one of: an operating environment of the heavy-duty vehicle and a transport mission of the heavy-duty vehicle. The digital twin is configured to model an as-is performance of the heavy-duty vehicle in at least one of: the operating environment and in executing the transport mission. The digital twin is configured to model expected performance of the heavy-duty vehicle with one or more add-on features enabled and in at least one of: the operating environment and in executing the transport mission. The digital twin is configured to compare the as-is performance and the expected performance to determine the influence on expected performance of the heavy-duty vehicle by enabling the one or more add-on features. An advantage of this may be that it is possible to obtain information regarding the influence, e.g. a change, on the vehicle's performance if the one or more add-on features are enabled without actually enabling the add-on feature, i.e. a simulation of the feature's influence on the vehicle's performance may be obtained. With this, the number of features that the vehicle is equipped with during manufacturing, e.g. from start, may be reduced or limited, and advanced features does not have to be installed in all vehicles. Instead, the add-on feature may be enabled or rolled out to vehicles that would benefit from the add-on feature, as determined based on evaluating the expected performance and not to all vehicles.

According to one embodiment, the digital twin may be configured to, if the expected performance is determined to be influenced, trigger an enabling procedure for the one or more add-on features in the heavy-duty vehicle or providing information indicating the influence on the expected performance of the heavy-duty vehicle to an external system. An advantage of the triggering of the enabling procedure may be that it provides an easy and fast way of enabling the add-on feature or of providing the add-on feature to the vehicle. The trigger may be an automatic trigger such that there is no need for or limited need for manual work relating to the enabling procedure. An advantage of providing information indicating the influence on the expected performance may be that the external system may perform analysis of whether the add-on feature should be enabled or provided to the vehicle. There is no need for processing capacity in the digital twin to perform the analysis since the analysis may be performed by an external system. With the providing of information to an external system, the influence on the expected performance may be visualized such that it easy for an operator of the external system to take the necessary actions.

According to a further embodiment, the one or more add-on features may be one or more software features and/or one or more hardware features for the heavy-duty vehicle.

According to another embodiment, the digital twin may be configured to determine, according to a performance metric, the influence on the expected performance of the heavy-duty vehicle that the one or more add-on features contribute to. The enabling procedure in the heavy-duty vehicle may be triggered or the information indicating the influence on the expected performance may be provided to an external system when the amount is above a threshold. An advantage of this may be that only an expected performance that contributes to more than a certain influence, e.g. an amount of change, may trigger the enabling procedure or the providing of the information to the external system. Thus, there need to a be a significant influence in order for the enabling procedure to be trigger or the information to be provided to the external system. If the influence is below the threshold, the influence may be determined to be not sufficient in order to trigger the enabling procedure or to provide the information to the external system.

According to a further embodiment, the one or more add-on features may be associated with at least one of: a motion management system, a connectivity system, a driver support system such as a reverse assist system, one or more auxiliary devices, alternative set of tyres, alternative tyre pressure. Thus, multiple add-on features may benefit from the digital twin. A vehicle user or owner may be provided with the possibility to evaluate the performance of a variety of add-on features before he decides if the vehicle should be provided with the feature or if the feature should be enabled.

According to a second aspect of the invention, the object is achieved by a method according to claim 6. The method is performed by the digital twin and is for determining an influence on an expected performance of a heavy-duty vehicle by enabling one or more add-on features. The digital twin comprises a digital model of the heavy-duty vehicle. The digital twin models at least one of: an operating environment of the heavy-duty vehicle and a transport mission of the heavy-duty vehicle. The digital twin models an as-is performance of the heavy-duty vehicle in at least one of: the operating environment and in executing the transport mission. The digital twin models the expected performance of the heavy-duty vehicle with one or more add-on features enabled and in at least one of: the operating environment and in executing the transport mission. The digital twin compares the as-is performance and the expected performance to determine the influence on the expected performance of the heavy-duty vehicle by enabling the one or more add-on features. Advantages and effects of the method are largely analogous to the advantages and effects of the digital twin. Further, all embodiments of the digital twin are applicable to and combinable with all embodiments of the method, and vice versa.

According to an embodiment, if the expected performance is determined to be influence, e.g. changed, the digital twin may trigger an enabling procedure for the one or more add-on features in the heavy-duty vehicle or provides information indicating the influence on the expected performance to an external system.

According to another embodiment, the one or more add-on features may be one or more software features and/or one or more hardware features for the heavy-duty vehicle.

According to another embodiment, the digital twin may determine, according to a performance metric, the influence on the expected performance of the heavy-duty vehicle that the one or more add-on features contribute to. The enabling procedure for the one or more add-on features in the heavy-duty vehicle may be triggered or the information indicating influence on the expected performance is provided to an external system when the influence is above a threshold.

According to a further embodiment, the one or more add-on features may be associated with at least one of: a motion management system, a connectivity system, a driver support system such as a reverse assist system, one or more auxiliary devices, alternative set of tyres, alternative tyre pressure.

According to a third aspect of the invention, the object is achieved by a heavy-duty vehicle according to claim 11. The heavy-duty vehicle comprises the digital twin of the first aspect. Advantages and effects of the digital twin are largely analogous to the advantages and effects of the heavy-duty vehicle. Further, all embodiments of the digital twin are applicable to and combinable with all embodiments of the heavy-duty vehicle, and vice versa.

According to a third aspect of the invention, the object is achieved by a computer program according to claim 12. The computer program comprises program code means for performing the steps of the method of the first aspect when the program is run on a computer.

According to a fourth aspect of the invention, the object is achieved by a computer readable medium according to claim 13. The computer readable medium carries a computer program comprising program code means for performing the method of the first aspect when the program product is run on a computer.

Further advantages and advantageous features of the invention are disclosed in the following description and in the dependent claims. A person skilled in the art will recognize additional features and advantages upon reading the following detailed description.

### BRIEF DESCRIPTION OF THE DRAWINGS

With reference to the appended drawings, below follows a more detailed description of embodiments of the invention cited as examples.

In the drawings:
- Fig. 1: is a schematic drawing illustrating a digital twin and a heavy-duty vehicle.
- Fig. 2: is a flow chart illustrating a method.
- Fig. 3a: is a schematic drawing illustrating a digital twin.
- Fig. 3b: is a schematic drawing illustrating a digital twin.

The drawings are not necessarily to scale and the dimensions of certain features may have been exaggerated for the sake of clarity. Emphasis is instead placed upon illustrating the principle of the embodiments herein.

### DETAILED DESCRIPTION OF EXAMPLE EMBODIMENTS OF THE INVENTION

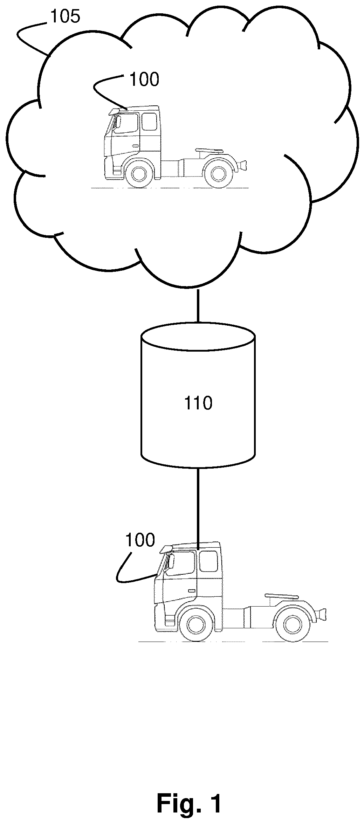

**Fig. 1** is a schematic drawing illustrating a **vehicle 100.** The vehicle 100 may be a heavy-duty vehicle such as for example a truck, buss, construction equipment. The vehicle 100 may also be other vehicles such as trailers, wheel loaders, articulated haulers, excavators, backhoe loaders, passenger cars, marine vessels, working machines, etc. For the sake of simplicity, the term vehicle will be used herein when referring to any of the above examples of vehicles.

Fig. 1 illustrates a **digital twin 105.** The digital twin 105 may be described as a digital representation or a digital model the vehicle 100. The term virtual representation and virtual model may also be used for the digital twin 105. The digital twin 105 is a digital representation of all components of the vehicle 100. The digital twin 105 mirrors the reality, i.e. the real vehicle 100. The digital twin 105 may be referred to as a first digital twin. The digital twin 105 may be comprised in the vehicle 100 or, in a computer system or in a cloud solution. The digital twin 105 may be a software in a fix location or as a set of distributed software packages that are interaction to the overall analysis performance, fix location or moving based on usage and other performance factors. The digital twin 105 may be completely comprised in the vehicle 100 or it may be completely comprised in another unit, e.g. a computer unit remotely located from the vehicle 100. The digital twin 105 may be distributed such that a first part of the digital twin 105 is located at a first location, e.g. comprised in the vehicle 100, and a second part of the digital twin 105 is located at a second location, e.g. comprised in a remote computer unit.

The digital twin 105 is arranged to obtain real-time and real-world operational data of the vehicle 100, e.g. real-time operational data, such that when a change occurs of the vehicle 100 in the real world, then the digital twin 105 is up to date with these changes.

The digital twin 105 and the vehicle 100 are therefore arranged to be connected to each other, via a wired communication link or a wired communication link. The digital twin 105 is arranged to dynamically change in accordance with real-world changes of the vehicle 100. This is different from general computer simulations which are not based on real-time data. Based on the operational data of the vehicle 100, the digital twin 105 may be arranged to model or predict operation of the vehicle 100, for example to model expected fuel consumption for a given scenario, predict a maintenance need etc. The digital twin 105 is arranged to simulate what is actually happening to an actual vehicle 100 in the real world, which is different to a simulation which simulates what could happen to a vehicle. The digital twin 105 is arranged to display the result of its modelling for example on a display of a tablet computer, a mobile phone, a stationary computer etc.

The digital twin 105 may be configured to model of at least one of:
- the operating environment in which the heavy-duty vehicle is expected to operate; and/or
- transport mission which the heavy-duty vehicle is expected to execute or follow.

Using other words, the first digital twin 105 may access a second digital twin which comprises a digital model of the the operating environment in which the heavy-duty vehicle is expected to operate. The first digital twin 105 may access a third digital twin which comprises a digital model of the transport mission which the heavy-duty vehicle is expected to execute or follow. With the second digital twin and the third digital twin, the first digital twin 105 may be configured to model at least one of: an operating environment of the heavy-duty vehicle 100 and a transport mission of the heavy-duty vehicle. Thus, there may be a first digital twin for the vehicle 100, second digital twin for the operating environment digital twin, and a third digital twin for the transport mission. Together, these digital models or digital twins may be described as a digital twin system comprising:
- the first digital twin 105 and the second digital twin, or
- the first digital twin 105 and the third digital twin, or
- the first digital twin 105 and the second digital twin and the third digital twin.

The operating environment may describe the environment which the vehicle 100 is expected to operate in or which it commonly operates in. The operating environment may be common loads, encountered road conditions such as gravel, low friction, temperature, humidity etc. The operating environment may be an operating condition.

The transport mission may describe a route that the vehicle 100 is configured to drive through, for example from location x to location y, via location z, it may describe the vehicle 100 should deliver a load of x kilograms from location x to location y etc. The transport mission may be fixed as the vehicle 100 drives through the route, or it may dynamically change as the vehicle 100 drive through the route.

The digital twin 105 may be implemented on and run on a **computer unit 110.** The computer unit 110 may comprise for example a processor, a memory storage, a communication interface etc. The computer unit 110 may comprise hardware and/or software. The computer unit 110 is arranged to enable data transfer between the vehicle 100 and the digital twin 105. The computer unit 110 may be arranged to store data obtained from the vehicle 100 and the digital twin 105, e.g. in a local memory unit comprised in the computer unit 110, in a central memory unit, in a cloud memory unit etc. The computer unit 110 and the vehicle 100 may be located at the same location or in different locations. The computer unit 110 may be remote server or comprised in a remote server. The computer unit 110 and the vehicle 100 may be located at the same location or in different locations. A first part of the computer unit 110 may be comprised in the vehicle 100 and a second part of the computer unit 110 may be comprised in another unit remotely located from the vehicle 100, i.e. the computer unit 110 may be a distributed computer unit. The computer unit 110 may be a remote server or comprised in a remote server which is remotely located with respect to the vehicle 100. The computer unit 110 may be partly or completely comprised in the vehicle 100

One or more add-on features may be provided to the vehicle 100. The add-on features may be provided to the vehicle 100 during manufacturing or at a later time instance. The add-on features which are comprised in the vehicle 100 may be arranged to be enabled or disabled. Some add-on features may be automatically enabled when they are provided to the vehicle 100, i.e. they are not necessarily arranged to be disabled. Enabling of an add-on feature that in the vehicle 100 may influence the expected performance of the vehicle 100 in various ways. Enabling of the add-on features may also involve a cost for the vehicle owner or user. The add-on feature may be referred to as an optional feature, an additional feature, an alternative feature, an extra feature, a supplementary feature or a vehicle feature. The add-on feature may, e.g., be associated with more advanced motion management software, for instance based on wheel end control by wheel slip instead of classic torque, which enables better handling in challenging conditions. These features are likely advantageous to some vehicles 100 but not all. The add-on feature may be associated with more advanced connectivity solutions, i.e., the activation of a higher throughput connectivity subscription service to facilitate some on-board function. The add-on feature may be for example related to a satellite communication system which may be retrofitted or simply be enabled in software. The add-on feature may be associated with more advanced reverse assist systems, allowing reversing on narrow forest roads and/or at challenging crowded logistics hubs for instance, if such conditions are regularly encountered. The one or more add-on features may be one or more software features and/or one or more hardware features for the heavy-duty vehicle 100. The add-on feature may be associated with at least one of: a motion management system, a connectivity system, a driver support system such as a reverse assist system, one or more auxiliary devices, alternative set of tyres and an alternative tyre pressure.

The digital twin 105, e.g. the first digital twin 105, is configured to model an as-is performance of the heavy-duty vehicle 100 in at least one of: the operating environment and in executing the transport mission. The as-is performance may be described as the performance without any add-on feature. The as-is performance may be a current performance. The digital twin 105 is configured to model an expected performance of the heavy-duty vehicle 100 with one or more add-on features enabled and in at least one of: the operating environment and in executing the transport mission. The expected performance may be a future performance. The digital twin 105 is configured to compare the as-is performance and the expected performance to determine the influence on the expected performance of the heavy-duty vehicle 100 by enabling the one or more add-on features. The expected performance may be influenced in that it may be changed, e.g. in that it increases or decreases, that it improves or worsens.

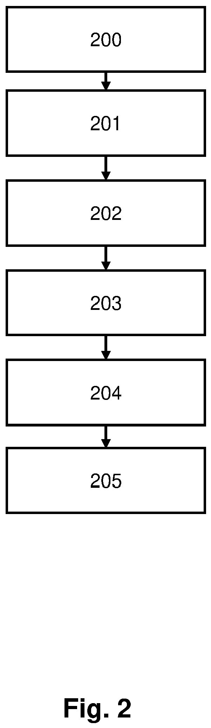

**Fig. 2** is a flow chart illustrating a method for determining an influence on an expected performance of the heavy-duty vehicle 100 by enabling one or more add-on features. The method is performed by the digital twin 105. As mentioned earlier, the digital twin 105 comprises a digital model of the heavy-duty vehicle 100. The digital twin 105 is configured to model at least one of: an operating environment of the heavy-duty vehicle 100 and a transport mission of the heavy-duty vehicle 100, e.g. by sending queries to the other digital model(s) etc. The method comprises at least one of the following steps, which steps may be performed in any suitable order than described below:

### Step 201

The digital twin 105 models an as-is performance of the heavy-duty vehicle 100 in at least one of: the operating environment and in executing the transport mission.

### Step 202

The digital twin 105 models the expected performance of the heavy-duty vehicle 100 with one or more add-on features enabled and in at least one of: the operating environment and in executing the transport mission.

The one or more add-on features may be one or more software features and/or one or more hardware features for the heavy-duty vehicle 100. The add-on feature may be associated with at least one of: a motion management system, a connectivity system, a driver support system such as a reverse assist system, one or more auxiliary devices, alternative set of tyres and an alternative tyre pressure

### Step 203

The digital twin 105 compares the as-is performance and the expected performance to determine the influence on the expected performance of the heavy-duty vehicle 100, e.g. changed, by enabling the one or more add-on features. A result of the comparison may be that the expected performance is higher, is increased, has improved, is lowered, has decreased, has worsened, as compared to the as-is performance. For example, the fuel consumption may increase if an add-on feature of a certain set of tyres is mounted on the vehicle 100, the signal strength of a communication link between the vehicle 100 and a transport mission server may increase if an add-on feature of an onboard connectivity system of a later release is installed in the vehicle 100.

### Step 204

The digital twin 105 may determine, according to a performance metric, the influence on the expected performance of the heavy-duty vehicle 100 that the one or more add-on features contribute to. The influence may be for example an amount of change of the expected performance.

### Step 205

If the expected performance is determined to be influenced, the digital twin 105 may trigger an enabling procedure for the one or more add-on features in the heavy-duty vehicle 100 or the digital twin 105 may provide information indicating the influence on the expected performance to an external system. The external system may be for example an external computer, a user equipment, e.g. a mobile phone, a tablet computer etc.

As a result of triggering the enabling procedure, the add-on feature, which is already installed in the vehicle 100 but is currently disabled, may be enabled. The enabling procedure may comprise to install and to enable the add-on feature in the vehicle 100 if it is not already installed in the vehicle 100. The enabling procedure may be an updating procedure which leads to an update of the vehicle 100 in that the add-on feature is installed and/or enabled in the vehicle 100.

As a result of the information indicating the influence on the expected performance, the external system may analyse the influence, e.g. a change, the information may be provided on a display for manual inspection by an operator etc. The external system may determine whether or not to enable or install the add-on feature in the vehicle.

The update procedure in the heavy-duty vehicle 100 may be triggered or the information indicating the influence on the expected performance may be provided to an external system when the influence, e.g. an amount of a change, is above a threshold, as may be determined in step 204. The threshold may be associated with an amount of fuel consumption, an amount of wheel wear-out, a percentage, a certain communication link signal strength etc. For example, if the expected performance contributes to more than X percent in reducing fuel consumption, that it contributes to less than Y percent of wheel wear out etc.

The digital twin 103 for determining an influence on the expected performance of a heavy-duty vehicle 100 by enabling one or more add-on features is arranged to perform the method described herein.

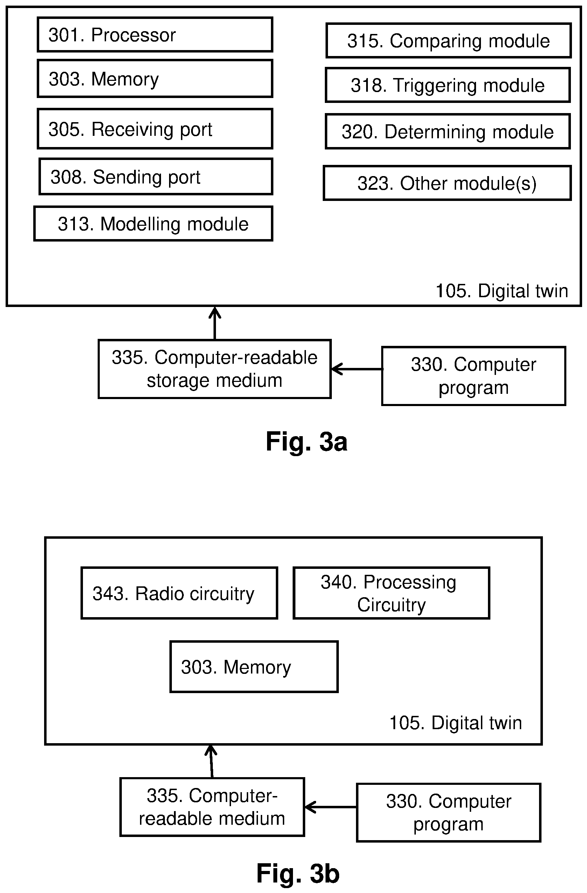

The digital twin 105 comprises a digital model of the heavy-duty vehicle 100. To perform the method steps shown in fig. 2 the digital twin 105 may comprise an arrangement as shown in one or both of **fig. 3a** and/or **fig. 3b.** Fig. 3a and fig. 3b depict two different examples of the arrangement that the digital twin 103 may comprise.

The present disclosure related to the digital twin 105 may be implemented through one or more processors, such as a **processor 301** depicted in fig. 3a, together with computer program code for performing the functions and actions described herein. A processor, as used herein, may be understood to be a hardware component. The program code mentioned above may also be provided as a computer program product, for instance in the form of a data carrier carrying computer program code for performing the present disclosure when being loaded into the digital twin 105. One such carrier may be in the form of a CD ROM disc. It is however feasible with other data carriers such as a memory stick. The computer program code may be provided as pure program code on a server and downloaded to the digital twin 105.

The digital twin 105 may comprise a **memory 303** comprising one or more memory units. The memory 303 is arranged to be used to store obtained information, store data, configurations, schedulings, and applications etc. to perform the methods herein when being executed in the digital twin 105.

The digital twin 105 may receive information and/or data from, e.g. the vehicle 100, the computer unit 110, another digital twin(s), a central computer, an external system, etc. through a **receiving port 305.** The receiving port 305 may be, for example, connected to one or more antennas in digital twin 105. The digital twin 105 may receive information from another structure in the system through the receiving port 305. Since the receiving port 305 may be in communication with the processor 301, the receiving port 305 may then send the received information to the processor 301. The receiving port 305 may also be configured to receive other information.

The processor 301 in the digital twin 105 may be configured to transmit or send information to e.g. the vehicle 100, the computer unit 110, another digital twin(s), a central computer, an external system or another structure in the system, through a **sending port 308,** which may be in communication with the processor 301, and the memory 303.

The digital twin 105 may comprise **a modelling module 313, a comparing module 315, a triggering module 318, a determining module 320, other module(s) 323** etc.

The digital twin 105 is arranged to, e.g. by means of the modelling module 313, model at least one of: an operating environment of the heavy-duty vehicle 100 and a transport mission of the heavy-duty vehicle 100. The modelling module 313 may also be referred to as a modelling unit, a modelling means, a modelling circuit, means for modelling etc. The modelling module 313 may be a processor 301 of the digital twin 105 or comprised in the processor 301 of the digital twin 105.

The digital twin 105 is arranged to, e.g. by means of the modelling module 313, model an as-is performance of the heavy-duty vehicle 100 in at least one of: the operating environment and in executing the transport mission.

The digital twin 105 is arranged to, e.g. by means of the modelling module 313, model expected performance of the heavy-duty vehicle 100 with one or more add-on features enabled and in at least one of: the operating environment and in executing the transport mission. The one or more add-on features may be one or more software features and/or one or more hardware features for the heavy-duty vehicle 100. The one or more add-on features may be associated with at least one of: a motion management system, a connectivity system, a driver support system such as a reverse assist system, one or more auxiliary devices, alternative set of tyres, alternative tyre pressure.

The digital twin 105 is arranged to, e.g. by means of the comparing module 315, compare the as-is performance and the expected performance to determine the influence on the expected performance of the heavy-duty vehicle 100 by enabling the one or more add-on features. The comparing module 315 may also be referred to as a comparing unit, a comparing means, a comparing circuit, means for comparing etc. The comparing module 315 may be a processor 301 of the digital twin 105 or comprised in the processor 301 of the digital twin 105.

The digital twin 105 may be arranged to, e.g. by means of the triggering module 318, if the expected performance is determined to be influenced, trigger an enabling procedure for the one or more add-on features in the heavy-duty vehicle 100 or providing information indicating influence on the expected performance to an external system. The enabling procedure in the heavy-duty vehicle 100 may be triggered or the information indicating the influence on the expected performance is provided to an external system when the amount is above a threshold. The triggering module 318 may also be referred to as a triggering unit, a triggering means, a triggering circuit, means for triggering etc. The triggering module 318 may be a processor 301 of the digital twin 105 or comprised in the processor 301 of the digital twin 105.

The digital twin 105 may be arranged to, e.g. by means of the determining module 320, determine, according to a performance metric, the influence, e.g. an amount of change, on the expected performance of the heavy-duty vehicle 100 that the one or more add-on features contribute to. The determining module 320 may also be referred to as a determining unit, a determining means, a determining circuit, means for determining etc. The determining module 320 may be a processor 301 of the digital twin 105 or comprised in the processor 301 of the digital twin 105.

Those skilled in the art will also appreciate that the modelling module 313, the comparing module 315, the triggering module 318, the determining module 320, other module(s) 323 etc. described above may refer to a combination of analogue and digital circuits, and/or one or more processors configured with software and/or firmware, e.g., stored in memory, that, when executed by the one or more processors such as the processor 301, perform as described above. One or more of these processors, as well as the other digital hardware, may be comprised in a single Application-Specific Integrated Circuit (ASIC), or several processors and various digital hardware may be distributed among several separate components, whether individually packaged or assembled into a System-on-a-Chip (SoC).

The different units 313-322 described above may be implemented as one or more applications running on one or more processors such as the processor 301.

Thus, the methods described herein for the digital twin 105 may be respectively implemented by means of a **computer program 330** product, comprising instructions, i.e., software code portions, which, when executed on at least one processor 301, cause the at least one processor 301 to carry out the actions described herein, as performed by the digital twin 105. The computer program 330 product may be stored on a **computer-readable storage medium 335.** The computer-readable storage medium 335, having stored thereon the computer program 330, may comprise instructions which, when executed on at least one processor 301, cause the at least one processor 301 to carry out the actions described herein, as performed by the digital twin 105. The computer-readable storage medium 335 may be a non-transitory computer-readable storage medium, such as a CD ROM disc, or a memory stick. The computer program 330 product may be stored on a carrier containing the computer program 330 just described, wherein the carrier is one of an electronic signal, optical signal, radio signal, or the first computer-readable storage medium 335, as described above.

The digital twin 105 may comprise a communication interface configured to facilitate communications between the digital twin 105 and other units, systems or devices, e.g., e.g. the vehicle 100, the computer unit 110, another digital twin(s), a central computer, an external system, or another structure. The interface may comprise a transceiver configured to transmit and receive radio signals over an air interface in accordance with a suitable standard.

The digital twin 105 may comprise the following arrangement depicted in fig.3b. The digital twin 105 may comprise a **processing circuitry 340,** e.g., one or more processors such as the processor 301, in the digital twin 105 and the memory 303. The digital twin 105 may also comprise a **radio circuitry 343,** which may comprise e.g., the receiving port 305 and the sending port 305. The processing circuitry 340 may be configured to, or operable to, perform the method actions according to fig. 2, in a similar manner as that described in relation to fig. 3a. The radio circuitry 343 may be configured to set up and maintain at least a wireless connection with the digital twin 105. Circuitry may be understood herein as a hardware component.

Hence, the present disclosure also relates to the digital twin 105 arranged to determine an influence on an expected performance of a heavy-duty vehicle 100. The digital twin 105 may comprise the processing circuitry 340 and the memory 303. The memory 303 comprises instructions executable by the processing circuitry 340. The digital twin 105 is operative to perform the actions described herein in relation to the digital twin 105, e.g., in fig. 2.

The method described herein for determining an influence on an expected performance of a heavy-duty vehicle 100 may be implemented through one or more processors, e.g. comprised in the computer unit 110, together with computer program code for performing the functions of the embodiments herein. The processor may be for example a Digital Signal Processor (DSP), Application Specific Integrated Circuit (ASIC) processor, Field-programmable gate array (FPGA) processor or microprocessor. The program code mentioned above may also be provided as a computer program product, for instance in the form of a data carrier carrying computer program code for performing the embodiments herein. One such carrier may be in the form of a CD ROM disc. It is however feasible with other data carriers such as a memory stick. The computer program code can furthermore be provided as pure program code on a server and downloaded to the computer unit 110.

A computer program may comprise program code means for performing the steps of the method described herein when the program is run on a computer, e.g. the computer unit 110, a computer comprised in the vehicle 100 etc. A computer readable medium may carry a computer program comprising program code means for performing the method describe herein when the program product is run on a computer, e.g. the computer unit 110, a computer comprised in the vehicle 100 etc.

The heavy-duty vehicle 100 may comprise the digital twin 105 described herein.

Summarized, the present invention enables activation of add-on features which are likely to influence the vehicle's operation in some way. This means that for example some advanced features g does not have to be rolled out to every vehicle 100, instead to a one or more selected vehicle 100 which are likely to benefit from the feature and is willing to accept the extra cost of the feature.

The digital twin 105 maintains a model of the vehicle 100 and also of the environment in which the vehicle 100 is operating, e.g., common loads, encountered road conditions such as gravel, low friction, etc. Based on the vehicle's operating environment, the digital twin 105 may evaluate the performance of one or more add-on features. If an add-on feature is deemed to influence the expected performance of the vehicle by some significant amount, a procedure may be triggered to provide an alert of the fact, e.g. to an external system, a driver, an operator, a vehicle owner etc. The external system, the driver, the operator, the vehicle owner may then decide if the add-on feature should be enabled, and obtain the expected influlence, or if the add-on feature is not worth the investment. It may also be determined to enable the ad-on feature if it contributes to more than X percent in reducing fuel consumption, that it contributes to less than Y percent of wheel wear out etc.

The digital twin 105 with the digital model of the vehicle 100 may be executed on a remote server. The digital twin is configured to model a common operating environment and/or transport mission of the vehicle 100. The digital twin 105 is configured to model a performance of the truck as-is in the common operating environment and/or in executing the mission. The digital twin is also configured to model expected performance of the vehicle 100 with one or more optional add-on features enabled in the common operating environment. If the performance is influenced, e.g. changed, by enabling or installing the one or more optional add-on features, then an update procedure or an installation procedure may be triggered such that the add-on feature is enabled or installed in the vehicle 100. If the performance is influenced, e.g. changed, by enabling or installing the one or more optional add-on features, then information indicating the influence on the performance may be provided to an external system.

The term "at least one of A and B" should be understood to mean "only A, only B, or both A and B.", where A and B are any parameter, number, indication used herein etc.

The term "adapted to" used herein may also be referred to as "arranged to", "configured to", "capable of' or "operative to".

It is to be understood that the present invention is not limited to the embodiments described herein and illustrated in the drawings; rather, the skilled person will recognize that many changes and modifications may be made within the scope of the appended claims.

## Claims

1. A digital twin (105) for determining the influence on an expected performance of a heavy-duty vehicle (100) by enabling one or more add-on features, wherein the digital twin (105) comprises a digital model of the heavy-duty vehicle (100), wherein the digital twin (105) is configured to:
model at least one of: an operating environment of the heavy-duty vehicle (100) and a transport mission of the heavy-duty vehicle (100);
model an as-is performance of the heavy-duty vehicle (100) in at least one of: the operating environment and in executing the transport mission;
model expected performance of the heavy-duty vehicle (100) with one or more add-on features enabled and in at least one of: the operating environment and in executing the transport mission; and to
compare the as-is performance and the expected performance to determine the influence on the expected performance of the heavy-duty vehicle (100) by enabling the one or more add-on features.

2. The digital twin (105) according to claim 1, configured to:
if the expected performance is determined to be influenced, trigger an enabling procedure for the one or more add-on features in the heavy-duty vehicle (100) or providing information indicating the influence on the expected performance of the heavy-duty vehicle (100) to an external system.

3. The digital twin (105) according any of the preceding claims, wherein the one or more add-on features are one or more software features and/or one or more hardware features for the heavy-duty vehicle (100).

4. The digital twin (105) according to any of claims 2-3, configured to:
determine, according to a performance metric, the influence on the expected performance of the heavy-duty vehicle (100) that the one or more add-on features contribute to; and
wherein the enabling procedure in the heavy-duty vehicle (100) is triggered or the information indicating the influence on the expected performance is provided to an external system when the amount is above a threshold.

5. The digital twin (105) according to any of the preceding claims, wherein the one or more add-on features are associated with at least one of: a motion management system, a connectivity system, a driver support system such as a reverse assist system, one or more auxiliary devices, alternative set of tyres, alternative tyre pressure.

6. A method performed by a digital twin (105) for determining an influence on an expected performance of a heavy-duty vehicle (100) by enabling one or more add-on features, wherein the digital twin (100) comprises a digital model of the heavy-duty vehicle (100), the method comprising:
*modelling* (200) at least one of: an operating environment of the heavy-duty vehicle (100) and a transport mission of the heavy-duty vehicle (100);
*modelling* (201) an as-is performance of the heavy-duty vehicle (100) in at least one of: the operating environment and in executing the transport mission;
*modelling* (202) the expected performance of the heavy-duty vehicle (100) with one or more add-on features enabled and in at least one of: the operating environment and in executing the transport mission; and
*comparing* (203) the as-is performance and the expected performance to determine an influence on the expected performance of the heavy-duty vehicle (100) by enabling the one or more add-on features.

7. The method according to claim 6, comprising:
if the expected performance is determined to be influenced, *triggering* (205) an enabling procedure for the one or more add-on features in the heavy-duty vehicle (100) or *providing* (205) information indicating the influence on the expected performance of the heavy-duty vehicle (100) to an external system.

8. The method according to either of claims 6-7, wherein the one or more add-on features are one or more software features and/or one or more hardware features for the heavy-duty vehicle (100).

9. The method according to either of claims 7-8, comprising:
*determining* (204), according to a performance metric, the influence on the expected performance of the heavy-duty vehicle (100) that the one or more add-on features contribute to; and
wherein the enabling procedure for the one or more add-on features in the heavy-duty vehicle (100) is triggered or the information indicating the influence on the expected performance is provided to an external system when the influence is above a threshold.

10. The method according to any of claims 6-9, wherein the one or more add-on features are associated with at least one of: a motion management system, a connectivity system, a driver support system such as a reverse assist system, one or more auxiliary devices, alternative set of tyres and an alternative tyre pressure.

11. A heavy-duty vehicle (100) comprising the digital twin (105) according to any of claims 1-5.

12. A computer program comprising program code means for performing the steps of any of claims 6-10 when the program is run on a computer.

13. A computer readable medium carrying a computer program comprising program code means for performing the steps of any of claims 6-10 when the program product is run on a computer.
